Europäisches Patentamt

European Patent Office

Office européen des brevets

(11) Veröffentlichungsnummer : **0 067 366**
**B1**

(12) **EUROPÄISCHE PATENTSCHRIFT**

(45) Veröffentlichungstag der Patentschrift :
30.12.86

(51) Int. Cl.⁴ : **H 03 K 17/945**

(21) Anmeldenummer : **82104840.2**

(22) Anmeldetag : **03.06.82**

(54) Elektrisches, insbesondere elektronisches, berührungslos arbeitendes Schaltgerät.

(30) Priorität : **12.06.81 DE 3123372**

(43) Veröffentlichungstag der Anmeldung :
**22.12.82 Patentblatt 82/51**

(45) Bekanntmachung des Hinweises auf die Patenterteilung : **30.12.86 Patentblatt 86/52**

(84) Benannte Vertragsstaaten :
**AT BE CH FR GB IT LI LU NL SE**

(56) Entgegenhaltungen :
**FR-A- 2 429 995**

(73) Patentinhaber : **i f m electronic gmbh**
**Teichstrasse 4**
**D-4300 Essen 1 (DE)**

(72) Erfinder : **Buck, Robert, Ing. grad.**
**Am Kirchbühl 28**
**D-7995 Neukirch (DE)**
Erfinder : **Lichte, Norbert, Ing. grad.**
**Säntisweg 14**
**D-7981 Schlier 1 (DE)**

(74) Vertreter : **Gesthuysen, Hans Dieter, Dipl.-Ing. et al**
**Patentanwälte Gesthuysen + von Rohr Huyssenallee**
**15 Postfach 10 13 33**
**D-4300 Essen 1 (DE)**

## Beschreibung

Die Erfindung betrifft ein elektrisches, insbesondere ein elektronisches, berührungslos arbeitendes Schaltgerät, mit einem Gehäuse, mindestens einem in dem Gehäuse vorgesehenen Bauelementeträger und zumindest teilweise auf dem Bauelementeträger angeordneten und zu einer elektrischen Schaltung miteinander verbundenen elektrischen und/oder elektronischen Bauelementen, wobei der Bauelementeträger aus einem flexiblen, elektrisch isolierenden Material besteht und Leiterbahnen zur elektrischen Verbindung der Bauelemente miteinander aufweist.

Elektrische Schaltgeräte der in Rede stehenden Art sind in einer großen Vielzahl von Ausführungsformen bekannt. Insbesondere sind solche Schaltgeräte als induktive oder kapazitive Annäherungsschalter bekannt, wobei dann ein von außen beeinflußbarer Oszillator, ggf. ein Schaltverstärker, ein von dem Oszillator — ggf. über den Schaltverstärker — steuerbarer elektronischer Schalter, z. B. ein Transistor, ein Thyristor oder ein Triac, und ggf. eine Speiseschaltung zur Erzeugung der Speisespannung für den Oszillator und ggf. für den Schaltverstärker verwirklicht sind.

Elektronische, berührungslos arbeitende Schaltgeräte, die also kontaktlos ausgeführt sind, werden in zunehmendem Maße anstelle von elektrischen, mechanisch betätigten Schaltgeräten, die kontaktbehaftet ausgeführt sind, in elektrischen Meß-, Steuer- und Regelkreisen verwendet. Bei elektronischen, berührungslos arbeitenden Schaltgeräten mit induktiver Beeinflussung des Oszillators gilt für den Oszillator, solange ein Metallteil einen vorgegebenen Abstand noch nicht erreicht hat, $K \cdot V = 1$ mit $K$ = Rückkopplungsfaktor und $V$ = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors $V$, so daß $K \cdot V < 1$ wird, d. h. der Oszillator hört auf zu schwingen. Bei elektronischen, berührungslos arbeitenden Schaltgeräten mit kapazitiver Beeinflussung des Oszillators gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, $K \cdot V < 1$, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors $K$, so daß $K \cdot V = 1$ wird, d. h. der Oszillator beginnt zu schwingen. Bei beiden Ausführungsformen wird abhängig von den unterschiedlichen Zuständen des Oszillators der elektronische Schalter, z. B. ein Transistor, ein Thyristor oder ein Triac, gesteuert.

Elektronische, berührungslos arbeitende Schaltgeräte sind anfangs mit einer Reihe von Problemen behaftet gewesen, — gemessen an elektrischen, mechanisch betätigten Schaltgeräten, nämlich u. a. mit den Problemen « Erzeugung einer Speisespannung für den Oszillator und ggf. für den Schaltverstärker », « Ausbildung des Oszillators », « Ausbildung des Schaltverstärkers », « Einschaltimpulsverhinderung », « Kurzschlußfestigkeit ». Mit diesen Problemen und deren Lösungen (und mit anderen bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141 und 30 38 692.

Neben den in der Vergangenheit bei Schaltgeräten der in Rede stehenden Art im wesentlichen schon gelösten elektrischen Problemen gibt es auch eine Reihe von teilweise noch ungelösten mechanischen Problemen. Ein solches Problem besteht darin, auf möglichst geringem Raum die insgesamt erforderlichen Bauelemente — bzw. bei vorgegebenem Raum möglichst viele Bauelemente — fertigungstechnisch optimal unterzubringen. Folglich liegt der Erfindung die Aufgabe zugrunde, ein Schaltgerät der in Rede stehenden Art anzugeben, bei dem auf möglichst geringem Raum die erforderlichen Bauelemente — bzw. bei vorgegebenem Raum möglichst viele Bauelemente — fertigungstechnisch optimal untergebracht werden können.

Das erfindungsgemäße, elektrische, insbesondere elektronische, berührungslos arbeitende Schaltgerät, bei dem die zuvor aufgezeigte Aufgabe gelöst ist, ist dadurch gekennzeichnet, daß zusätzlich zu dem Bauelementeträger ein — im wesentlichen flächenhafter — Hilfsträger vorgesehen ist, der Bauelementeträger auf beiden Seiten des Hilfsträgers angeordnet, nämlich einstückig um den Hilfsträger gefaltet ist und der Bauelementeträger nur auf den dem Hilfsträger abgewandten Seiten mit Bauelementen bestückt ist.

Die Lehre der Erfindung geht von der Überlegung aus, daß bei den im Stand der Technik bekannten elektrischen Schaltgeräten der in Rede stehenden Art die Bauelemente im wesentlichen nur in einer — durch den Bauelementeträger vorgegebenen — Ebene angeordnet sind. Dadurch, daß erfindungsgemäß ein Hilfsträger vorgesehen und der Bauelementeträger auf beiden Seiten des Hilfsträgers angeordnet ist, werden für die Unterbringung der Bauelemente zwei übereinanderliegende Ebenen realisiert, so daß der vorhandene Raum besser für die Unterbringung der Bauelemente ausgenutzt wird. Die Erfindung lehrt also eine besondere « Packungstechnik », die zu einer höheren « Packungsdichte » führt.

Im einzelnen gibt es verschiedene Möglichkeiten, das erfindungsgemäße Schaltgerät auszugestalten und weiterzubilden, was im folgenden nur beispielhaft erläutert werden soll.

Grundsätzlich könnte man daran denken, den Bauelementeträger zu teilen, so daß man zwei Bauelementeträgerhälften hat, und auf jeder Seite des Hilfsträgers eine Bauelementeträgerhälfte vorzusehen. Wesentlich vorteilhafter ist es jedoch, den Bauelementeträger einstückig um den Hilfsträger zu falten. Bei der Erfindung liegt also bei der Bestückung des Bauelementeträgers mit den Bauteilen und beim Verbinden der Bauteile miteinander ein « normaler » Bauelementeträger vor, der in üblicher Form mit allen Bauelementen bestückt werden kann und bei dem in üblicher Form die Bauelemente — mit Hilfe der vorhandenen Leiterbahnen — elektrisch miteinander verbunden werden können. Mit anderen Worten entfällt bei der Erfindung die Notwendigkeit, nachträglich Verbindungen zwischen einer Bauelementeträgerhälfte und der anderen Bauelementeträgerhälfte herstellen zu müssen, — eine Notwendigkeit, die dann gegeben ist, wenn man auf beiden Seiten des Hilfsträgers jeweils separate Bauelementeträgerhälften vorsieht.

Bei dem erfindungsgemäßen Schaltgerät ist der Bauelementeträger nur auf den dem Hilfsträger abgewandten Seiten mit Bauelementen bestückt. Es empfiehlt sich, einen Bauelementeträger zu verwenden, der nur auf den dem Hilfsträger zugewandten Seiten Leiterbahnen aufweist. Bei dieser Ausführungsform erhält man also einen Aufbau « Bauelemente — Bauelementeträger — Leiterbahnen — Hilfsträger — Leiterbahnen — Bauelementeträger — Bauelemente ».

Eine besonders bevorzugte Ausführungsform des erfindungsgemäßen Schaltgerätes ist nach einer weiteren Lehre der Erfindung dadurch gekennzeichnet, daß zusätzlich zu dem aus einem flexiblen, elektrisch isolierenden Material bestehenden Bauelementeträger mindestens ein aus Keramik bestehender Bauelementeträger vorgesehen ist. Ein solcher aus Keramik bestehender Bauelementeträger hat Vorteile — und Nachteile. Bei der bevorzugten Ausführungsform des erfindungsgemäßen Schaltgerätes, bei der zusätzlich zu dem aus einem flexiblen, elektrisch isolierenden Material bestehenden Bauelementeträger mindestens ein aus Keramik bestehender Bauelementeträger verwendet wird, können solche Bauelemente, für die ein aus Keramik bestehender Bauelementeträger besonders geeignet ist, auf dem aus Keramik bestehenden Bauelementeträger angeordnet sein, während der aus einem flexiblen, elektrisch isolierenden Material bestehende Bauelementeträger mit den übrigen Bauelementen bestückt ist. Bei dieser Ausführungsform können also die Vorteile eines aus Keramik bestehenden Bauelementeträgers ausgenutzt werden, ohne dessen Nachteile mit in Kauf nehmen zu müssen.

Ist bei dem erfindungsgemäßen Schaltgerät zusätzlich zu dem aus einem flexiblen, elektrisch isolierenden Material bestehenden Bauelementeträger mindestens ein aus Keramik bestehender Bauelementeträger vorgesehen, so empfiehlt es sich, den aus Keramik bestehenden Bauelementeträger mit Hilfe von Distanzstiften auf dem aus einem flexiblen, elektrisch isolierenden Material bestehenden Bauelementeträger zu befestigen, wobei dann die Distanzstifte zumindest teilweise auch der elektrischen Verbindung zwischen den Bauelementen auf dem aus Keramik bestehenden Bauelementeträger und den Bauelementen auf dem aus einem flexiblen, elektrisch isolierenden Material bestehenden Bauelementeträger dienen können. Dabei empfiehlt es sich, die Anordnung so zu treffen, daß der aus Keramik bestehende Bauelementeträger nur auf der dem aus einem flexiblen, elektrisch isolierenden Material bestehenden Bauelementeträger zugewandten Seite mit Bauelementen bestückt ist und nur auf der dem aus einem flexiblen, elektrisch isolierenden Material bestehenden Bauelementeträger abgewandten Seite Leiterbahnen aufweist.

Bei elektrischen Schaltgeräten der in Rede stehenden Art in der Ausführungsform als induktive Annäherungsschalter gehört zu den Bauelementen eine Spule, die vorzugsweise in einem einseitig offenen Ferrittopf angeordnet ist. Dann empfiehlt es sich, den aus einem flexiblen, elektrisch isolierenden Material bestehenden Bauelementeträger einseitig mit einem Spulenbefestigungsteil zu versehen. Dabei kann das Spulenbefestigungsteil symmetrisch zur Mittellinie einer Hälfte des Bauelementeträgers oder symmetrisch zur Mittellinie des Bauelementeträgers vorgesehen sein. In beiden Fällen empfiehlt es sich, die Spule bzw. den die Spule aufnehmenden Ferrittopf an seiner geschlossenen Seite mit einem Zapfen und den Spulenbefestigungsteil mit einer dem Zapfen der Spule bzw. des Ferrittopfes zugeordneten Ausnehmung zu versehen, — so daß der Zapfen der Spule bzw. des Ferrittopfes in die Ausnehmung des Spulenbefestigungsteils gesteckt und so die Spule relativ zum Bauelementeträger besonders einfach fixiert werden kann. Bei dieser Ausführungsform empfiehlt es sich weiter, den Hilfsträger mit einer dem Zapfen der Spule bzw. des Ferrittopfes zugeordneten Aufnahme zu versehen. Dadurch läßt sich einerseits die Spule besonders einfach mit dem hinreichend stabilen Hilfsträger verbinden, wird andererseits auch der aus einem flexiblen, elektrisch isolierenden Material bestehende Bauelementeträger mit dem Hilfsträger verbunden.

Im übrigen empfiehlt es sich, bei dem erfindungsgemäßen Schaltgerät den — aus einem flexiblen, elektrisch isolierenden Material bestehenden — Bauelementeträger und den Hilfsträger miteinander zu verkleben. Dazu kann der Hilfsträger mehrere vorzugsweise senkrecht zu seiner Längsachse verlaufende Klebstoffaufnahmen aufweisen, so daß in diese Klebstoffaufnahmen eingebrachte Klebstofftropfen durch Kapillarwirkung über die gesamte Breite des Hilfsträgers — und des Bauelementeträgers — « wandern ».

Im folgenden wird die Erfindung anhand einer lediglich ein Ausführungsbeispiel darstellenden Zeichnung erläutert ; es zeigt

Figur 1 schematisch, eine bevorzugte Ausführungsform eines erfindungsgemäßen elektronischen, berührungslos arbeitenden Schaltgerätes, nämlich eines induktiven Annäherungsschalters, teilweise aufgeschnitten,

Figur 2 einen Schnitt durch das elektronische Schaltgerät nach Fig. 1 längs der Linie II-II,

Figur 3 eine Skizze zur Erläuterung der Befestigung der zu dem dargestellten Schaltgerät gehörenden Spule und

Figur 4 eine der Fig. 3 entsprechende Skizze einer Ausführungsform des erfindungsgemäßen Schaltgerätes, die sich geringfügig von der Ausführungsform nach Fig. 3 unterscheidet.

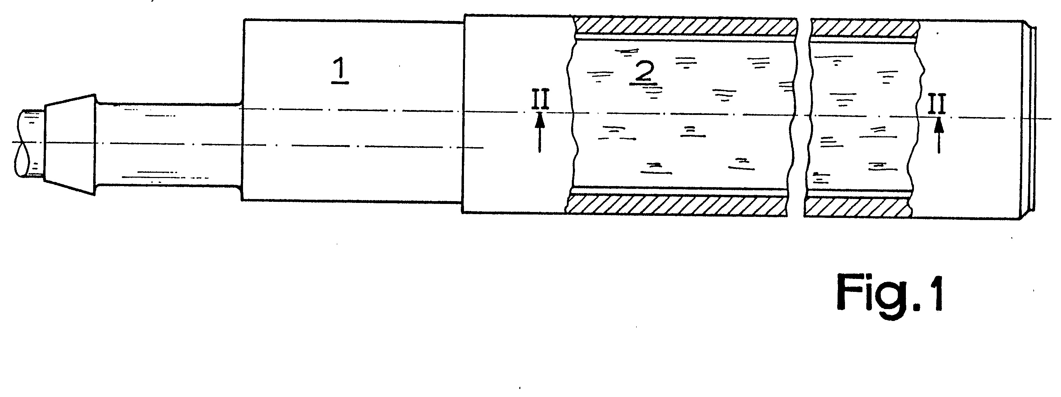

Das in Fig. 1 dargestellte elektronische, berührunglos arbeitende Schaltgerät weist ein Gehäuse 1, einen in dem Gehäuse 1 vorgesehenen Bauelementeträger 2 und teilweise auf dem Bauelementeträger 2 angeordnete und zu einer elektrischen Schaltung miteinander verbundene elektrische und elektronische Bauelemente 3 auf. Der Bauelementeträger 2 besteht aus Captonfilm od. dgl. und weist im einzelnen nicht dargestellte Leiterbahnen zur elektrischen Verbindung der Bauelemente 3 auf.

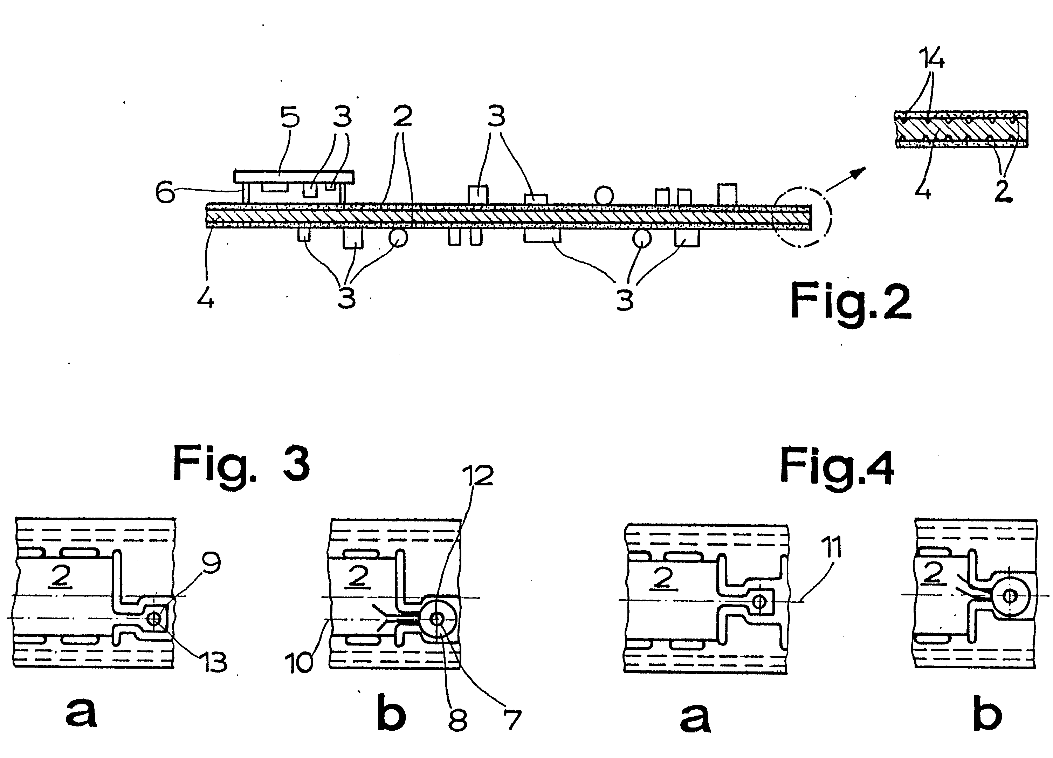

Wie die Fig. 2 zeigt, ist bei dem erfindungsgemäßen Schaltgerät zusätzlich zu dem Bauelementeträger 2 ein — im wesentlichen flächenhafter — Hilfsträger 4 vorgesehen und ist der Bauelementeträger 2 auf beiden Seiten des Hilfsträgers 4 angeordnet ; der Bauelementeträger 3 ist einstückig um den Hilfsträger 4 gefaltet. Wie die Fig. 2 zeigt, ist der Bauelementeträger 2 nur auf den dem Hilfsträger 4 abgewandten Seiten mit Bauelementen 3 bestückt, — während der Bauelementeträger 2 nur auf den dem Hilfsträger 4 zugewandten Seiten die nicht dargestellten Leiterbahnen aufweist.

Im übrigen zeigt die Fig. 2 insoweit eine bevorzugte Ausführungsform des erfindungsgemäßen Schaltgerätes, als zusätzlich zu dem aus Captonfilm od. dgl. bestehenden Bauelementeträger 2 ein aus Keramik od. dgl. bestehender Bauelementeträger 5 vorgesehen ist. Der aus Keramik od. dgl. bestehende Bauelementeträger 5 ist mit Hilfe von Distanzstiften 6 auf dem aus Captonfilm od. dgl. bestehenden Bauelementeträger 2 befestigt ; die Distanzstifte 6 dienen auch der elektrischen Verbindung zwischen den Bauelementen 3 auf dem aus Keramik od. dgl. bestehenden Bauelementeträger 5 und den Bauelementen 3 auf dem aus Captonfilm od. dgl. bestehenden Bauelementeträger 2. Der aus Keramik od. dgl. bestehende Bauelementeträger 5 ist nur auf der dem aus Captonfilm od. dgl. bestehenden Bauelementeträger 2 zugewandten Seite mit Bauelementen 3 bestückt und weist nur auf der dem aus Captonfilm od. dgl. bestehenden Bauelementeträger 2 abgewandten Seite nicht dargestellte Leiterbahnen auf.

Zu dem dargestellten elektronischen Schaltgerät gehört eine Spule 7, die in einem einseitig offenen Ferrittopf 8 angeordnet ist. Wie die Fig. 3 und 4 — als Ausschnitt aus dem Fertigungsprozeß — zeigen, weist der aus Captonfilm od. dgl. bestehende Bauelementeträger 2 einseitig ein Spulenbefestigungsteil 9 auf. Im Ausführungsbeispiel nach Fig. 3 ist das Spulenbefestigungsteil 9 symmetrisch zur Mittellinie 10 einer Hälfte des Bauelementeträgers 2 vorgesehen, während im Ausführungsbeispiel nach Fig. 4 das Spulenbefestigungsteil 9 symmetrisch zur Mittellinie 11 des Bauelementeträgers 2 vorgesehen ist. Wie ein Vergleich der Teile a) mit den Teilen b) der Fig. 3 und 4 erkennen läßt, weist der die Spule 7 aufnehmende Ferrittopf 8 an seiner geschlossenen Seite einen Zapfen 12 auf und ist das Spulenbefestigungsteil 9 mit einer dem Zapfen 12 des Ferrittopfes 8 zugeordneten Ausnehmung 13 versehen. (Nicht dargestellt ist, daß der Hilfsträger mit einer dem Zapfen der Spule bzw. des Ferrittopfes zugeordneten Aufnahme versehen sein kann).

Schließlich sind der Bauelementeträger 2 und der Hilfsträger 4 miteinander verklebt. Dazu weist der Hilfsträger 4, wie dies der herausgezogene Ausschnitt aus Fig. 2 zeigt, mehrere senkrecht zu seiner Längsachse verlaufende Klebstoffaufnahmen 14 auf.

## Patentansprüche

1. Elektrisches, insbesondere elektronisches, berührungslos arbeitendes Schaltgerät, mit einem Gehäuse, mindestens einem in dem Gehäuse vorgesehenen Bauelementeträger und zumindest teilweise auf dem Bauelementeträger angeordneten und zu einer elektrischen Schaltung miteinander verbundenen elektrischen und/oder elektronischen Bauelementen, wobei der Bauelementeträger aus einem flexiblen, elektrisch isolierenden Material besteht und Leiterbahnen zur elektrischen Verbindung der Bauelemente miteinander aufweist, dadurch gekennzeichnet, daß zusätzlich zu dem Bauelementeträger (2) ein — im wesentlichen flächenhafter — Hilfsträger (4) vorgesehen ist, der Bauelementeträger (2) auf beiden Seiten des Hilfsträgers (4) angeordnet, nämlich einstückig um den Hilfsträger (4) gefaltet ist und der Bauelementeträger (2) nur auf den dem Hilfsträger (4) abgewandten Seiten mit Bauelementen (3) bestückt ist.

2. Elektrisches Schaltgerät nach Anspruch 1, dadurch gekennzeichnet, daß der Bauelementeträger (2) nur auf den dem Hilfsträger (4) abgewandten Seiten Leiterbahnen aufweist.

3. Elektrisches Schaltgerät nach Anspruch 1 oder 2, dadurch gekennzeichnet, daß zusätzlich zu dem aus einem flexiblen, elektrisch isolierenden Material bestehenden Bauelementeträger (2) mindestens ein aus Keramik bestehender Bauelementeträger (5) vorgesehen ist.

4. Elektrisches Schaltgerät nach Anspruch 3, dadurch gekennzeichnet, daß der aus Keramik bestehende Bauelementeträger (5) mit Hilfe von Distanzstiften (6) auf dem aus einem flexiblen, elektrisch isolierenden Material bestehenden Bauelementeträger (2) befestigt ist und die Distanzstifte (6) zumindest teilweise auch der elektrischen Verbindung zwischen den Bauelementen (3) auf dem aus Keramik bestehenden Bauelementeträger (5) und den Bauelementen (3) auf dem aus einem flexiblen, elektrisch isolierenden Material bestehenden Bauelementeträger (2) dienen.

5. Elektrisches Schaltgerät nach Anspruch 4, dadurch gekennzeichnet, daß der aus Keramik bestehende Bauelementeträger (5) nur auf der dem aus einem flexiblen, elektrisch isolierenden Material bestehenden Bauelementeträger (2) zugewandten Seite mit Bauelementen (3) bestückt ist und nur auf der dem aus einem flexiblen, elektrisch isolierenden Material bestehenden Bauelementeträger (2) zugewandten Seite Leiterbahnen aufweist.

6. Elektrisches Schaltgerät nach einem der Ansprüche 1 bis 5, bei dem zu den Bauelementen eine Spule gehört und die Spule vorzugsweise in einem einseitig offenen Ferrittopf angeordnet ist, dadurch gekennzeichnet, daß der aus einem flexiblen, elektrisch isolierenden Material bestehende Bauelementeträger (2) einseitig ein Spulenbefestigungsteil (9) aufweist.

7. Elektrisches Schaltgerät nach Anspruch 6, dadurch gekennzeichnet, daß das Spulenbefestigungsteil (9) symmetrisch zur Mittellinie (10) einer Hälfte des Bauelementeträgers (2) vorgesehen ist.

8. Elektrisches Schaltgerät nach Anspruch 6, dadurch gekennzeichnet, daß das Spulenbefestigungsteil (9) symmetrisch zur Mittellinie (11) des Bauelementeträgers (2) vorgesehen ist.

9. Elektrisches Schaltgerät nach einem der Ansprüche 6 bis 8, dadurch gekennzeichnet, daß die Spule bzw. der die Spule (7) aufnehmende Ferrittopf (8) an seiner geschlossenen Seite einen Zapfen (12) aufweist und das Spulenbefestigungsteil (9) mit einer dem Zapfen (12) der Spule bzw. des Ferrittopfes (8) zugeordneten Ausnehmung (13) versehen ist.

10. Elektrisches Schaltgerät nach Anspruch 9, dadurch gekennzeichnet, daß der Hilfsträger mit einer dem Zapfen der Spule des Ferrittopfes zugeordneten Aufnahme versehen ist.

11. Elektrisches Schaltgerät nach einem der Ansprüche 1 bis 10, dadurch gekennzeichnet, daß der Bauelementeträger (2) und der Hilfsträger (4) miteinander verklebt sind.

12. Elektrisches Schaltgerät nach Anspruch 11, dadurch gekennzeichnet, daß der Hilfsträger (4) mehrere vorzugsweise senkrecht zu seiner Längsachse verlaufende Klebstoffaufnahmen (14) aufweist.

## Claims

1. Electrical, particularly electronic, switching equipment operable without contact, with a housing, at least one component carrier provided in the housing and electrical and/or electronic components at least part of which are located on the component carrier and connected together to form an electrical circuit, in which the component carrier consists of a flexible, electrically insulating material and possesses conducting paths for electrical connection of the components to one another, characterized in that, in addition to the component carrier (2), an auxiliary carrier (4) — basically flat and thin — is provided, that the component carrier (2) is located on both sides of the auxiliary carrier (4), namely by being folded around it as a single piece, and that the component carrier (2) is only equipped with components (3) on its sides that face away from the auxiliary carrier (4).

2. Electrical switching equipment according to Claim 1, characterized in that the component carrier (2) only possesses conducting paths on its sides that face towards the auxiliary carrier (4).

3. Electrical switching equipment according to Claim 1 or 2, characterized in that, in addition to the component carrier (2) which consists of flexible, electrically insulating material, at least one carrier (5) consisting of ceramics is provided.

4. Electrical switching equipment according to Claim 3, characterized in that the component carrier (5) consisting of ceramics is fastened to the component carrier (2) consisting of a flexible, electrically insulating material by means of distance studs (6), and the distance studs (6) at least in part also serve as electrical connections between the components (3) on the component carrier (5) consisting of ceramics and the components (3) on the component carrier (2) consisting of a flexible, electrically insulating material.

5. Electrical switching equipment according to Claim 4, characterized in that the component carrier (5) consisting of ceramics is only equipped with components (3) on the side facing towards the component carrier (2) consisting of a flexible, electrically insulating material and only possesses conducting paths on the side facing away from the component carrier (2) consisting of a flexible, electrically insulating material.

6. Electrical switching equipment according to one of Claims 1 to 5 in which the components include a coil and the coil is preferably located in a ferrite pot open on one side, characterised in that the component carrier (2) consisting of a flexible, electrically insulating material possesses a coil-fixing component (9) on one side.

7. Electrical switching equipment according to Claim 6, characterized in that the coil-fixing component (9) is provided symmetrically to the central line (10) of one half of the component carrier (2).

8. Electrical switching equipment according to Claim 6, characterized in that the coil-fixing component (9) is provided symmetrically to the central line (11) of the component carrier (2).

9. Electrical switching equipment according to one of Claims 6 to 8, characterized in that the coil or the ferrite pot (8) holding the coil (7) possesses a peg (12) on its closed side and the coil-fixing component (9) is provided with a recess (13) into which the peg (12) of the coil or ferrite pot (8) fits.

10. Electrical switching equipment according to Claim 9, characterized in that the auxiliary carrier is provided with a recess into which the peg of the coil or ferrite pot fits.

11. Electrical switching equipment according to one of Claims 1 to 10, characterized in that the component carrier (2) and the auxiliary carrier (4) are held together by adhesive.

12. Electrical switching equipment according to Claim 11, characterized in that the auxiliary carrier (4) possesses several recesses (14) for adhesive, preferably running transversely to its longitudinal axis.

**Revendications**

1. Dispositif de commutation électrique et, en particulier, électronique fonctionnant sans contact, comportant un boîtier, au moins un support d'éléments constructifs disposé dans le boîtier et des éléments constructifs électriques et/ou électroniques disposés, au moins partiellement, sur le support d'éléments constructifs et reliés les uns aux autres pour former un circuit électrique, le support d'éléments constructifs étant réalisé en un matériau flexible électriquement isolant et présentant des bandes conductrices assurant la liaison électrique des éléments constructifs entre eux, caractérisé en ce qu'il est prévu, outre le support d'éléments constructifs (2), un support auxiliaire (4) de forme essentiellement plate, que le support d'éléments constructifs (2) est disposé de part et d'autre du support auxiliaire (4), en étant replié d'une pièce autour du support auxiliaire (4) et que le support d'éléments constructifs (2) n'est garni d'éléments constructifs (3) que sur ses faces opposées au support auxiliaire (4).

2. Dispositif de commutation électrique selon la revendication 1, caractérisé en ce que le support d'éléments constructifs (2) ne présente des bandes conductrices que sur ses faces opposées au support auxiliaire (4).

3. Dispositif de commutation électrique selon la revendication 1 ou 2, caractérisé en ce que, outre le support d'éléments constructifs (2) réalisé en un matériau flexible électriquement isolant, il est prévu au moins un support d'éléments constructifs (5) réalisé en céramique.

4. Dispositif de commutation électrique selon la revendication 3, caractérisé en ce que le support d'éléments constructifs (5) réalisé en céramique est fixé à l'aide de broches d'écartement (6) sur le support d'éléments constructifs (2) réalisé en un matériau flexible électriquement isolant, et que les broches d'écartement (6) servent, au moins partiellement, à assurer également la connexion électrique entre les éléments constructifs (3) disposés sur le support d'éléments constructifs (2) en céramique et les éléments constructifs (3) disposés sur le support d'éléments constructifs (2) réalisé en un matériau flexible électriquement isolant.

5. Dispositif de commutation électrique selon la revendication 4, caractérisé en ce que le support d'éléments constructifs (5) réalisé en céramique n'est garni d'éléments constructifs (3) que sur sa face tournée vers le support d'éléments constructifs (2) réalisé en un matériau flexible électriquement isolant et ne présente des bandes conductrices que sur sa face tournée vers le support d'éléments constructifs (2) réalisé en un matériau flexible électriquement isolant.

6. Dispositif de commutation électrique selon l'une des revendications 1 à 5, les éléments constructifs comprenant une bobine et la bobine étant disposée, de préférence, dans une cuvette de ferrite ouverte d'un côté, caractérisé en ce que le support d'éléments constructifs (2) réalisé en un matériau flexible électriquement isolant comporte, d'un côté, une pièce de fixation de la bobine (9).

7. Dispositif de commutation électrique selon la revendication 6, caractérisé en ce que la pièce de fixation de la bobine (9) est disposée symétriquement par rapport à l'axe (10) d'une moitié du support d'éléments constructifs (2).

8. Dispositif de commutation électrique selon la revendication 6, caractérisé en ce que la pièce de fixation de la bobine (9) est disposée symétriquement par rapport à l'axe (11) du support d'éléments constructifs (2).

9. Dispositif de commutation électrique selon l'une des revendications 6 à 8, caractérisé en ce que la bobine ou la cuvette de ferrite (8) contenant la bobine (7) présente, sur sa face fermée, un tourillon (12) et que la pièce de fixation de la bobine (9) est pourvue d'une cavité (13) correspondant au tourillon (12) de la bobine ou de la cuvette de ferrite (8).

10. Dispositif de commutation électrique selon la revendication 9, caractérisé en ce que le support auxiliaire est pourvu d'une cavité correspondant au tourillon de la bobine de la cuvette de ferrite.

11. Dispositif de commutation électrique selon l'une des revendications 1 à 10, caractérisé en ce que le support d'éléments constructifs (2) et le support auxiliaire (4) sont assemblés l'un à l'autre par collage.

12. Dispositif de commutation électrique selon la revendication 11, caractérisé en ce que le support auxiliaire (4) présente plusieurs cavités pour colle (14), disposées de préférence perpendiculairement à son axe longitudinal.

Fig.1

0 067 366

Fig.2

Fig. 3

a

b

Fig.4

a

b

0 067 366